# EUROPEAN PATENT APPLICATION

(11) **EP 2 743 317 A1**
(43) Date of publication of application: **18.06.2014**
(21) Application number: 12822463.1
(22) Date of filing: 08.08.2012
(51) Int. Cl.: C08L 101/00, C08K 3/04, C08L 33/04, C08L 71/02, C08L 75/04, H01B 1/20, H01B 5/16, H04R 19/02, H04R 19/04, H05K 1/09, H05K 9/00

(54) **FLEXIBLE CONDUCTIVE MATERIAL**

(30) Priority: 10.08.2011 JP 2011174495
(71) Applicant: Tokai Rubber Industries, Ltd., Komaki-shi, Aichi 485-8550 (JP)
(72) Inventor: KOBAYASHI, Jun, Komaki-shi Aichi 485-8550 (JP); TAGUCHI, Yutaro, Komaki-shi Aichi 485-8550 (JP); YOSHIKAWA, Hitoshi, Komaki-shi Aichi 485-8550 (JP)
(74) Representative: Müller-Boré & Partner Patentanwälte PartG mbB
(86) International application number: PCT/JP2012/070219
(87) International publication number: WO 2013/022030

(57) **Abstract**

An elastic conductive material includes a matrix and a conductor dispersed in the matrix. The matrix is formed by crossliking a first polymer that is one or more selected from polymers of General Formulae (1) to (4) below and has a function of dispersing the conductor, and a second polymer crosslinkable with the first polymer.
[In Formulae (1) to (4), X is a substituent crosslinkable with the second polymer; Y is a functional group having an affinity for the conductor; constitutional units A, B, and C each are one kind selected from acrylic acid, methacrylic acid, salts of acrylic acid and methacrylic acid, esters, polybutadiene, polyisoprene, urethane prepolymer, polyether, polyetheramine, polyamine, polyol, and polythiol; and 1, m, and n each are an integer equal to or greater than one.]

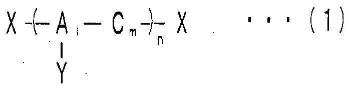

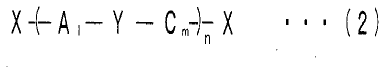

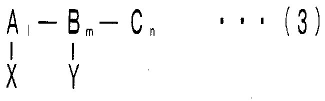

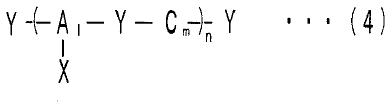

## Description

### TECHNICAL FIELD

The present invention relates to an elastic conductive material suitable for expandable/contradictable electrodes, wires, electromagnetic shields, and the like.

### BACKGROUND ART

Development of highly elastic, compact, and lightweight transducers has advanced using polymer materials such as elastomers. A transducer of this type is configured, for example, with an elastomer dielectric film sandwiched between electrodes. In such a transducer, the dielectric film expands/contracts depending on the magnitude of the applied voltage. The electrodes are therefore required to be expandable/contractible in accordance with deformation of the dielectric film so as not to obstruct expansion and contraction of the dielectric film.

As electronic equipment has been increasingly digitized, increased in a frequency, and reduced in size, it has become important to develop electromagnetic shields for blocking unnecessary electromagnetic waves. Elasticity is often required of electromagnetic shields in wiring application for electronic equipment having elasticity and expandability/contractibility, for example.

In view of the foregoing, a conductive material formed of an elastomer filled with conductive carbon or metal powder is proposed (see, for example, Patent Document 1).

### Related Art Documents

### Patent Documents

Patent Document 1: Japanese Patent Application Publication No. 2009-227985 (JP 2009-227985 A)
Patent Document 2: Japanese Patent Application Publication No. 2000-169763 (JP 2000-169763 A)
Patent Document 3: Japanese Patent Application Publication No. 2004-97955 (JP 2004-97955 A)

### SUMMARY OF THE INVENTION

### Problem to be Solved by the Invention

For example, conductors such as carbon black and carbon nanotubes easily agglomerate because they have a strong cohesive force. If a conductor agglomerates in an elastomer (matrix), the matrix easily breaks starting from the agglomerate. Furthermore, sufficient conductivity cannot be obtained because a conductive network is not easily formed in the matrix. Here, if a large amount of conductor is blended in order to exhibit desired conductivity, the intrinsic elasticity of the elastomer is impaired and the elongation of the matrix decreases. Therefore, in order to achieve both elasticity and conductivity of a conductive material, it is necessary to disperse a conductor in a matrix as uniformly as possible.

For example, as described in Patent Document 2, the dispersibility of a conductor in a matrix can be improved by blending a dispersant. The dispersant, however, is required to quickly disperse to be adsorbed to the conductor and suppress gathering of the conductor. For this reason, most of dispersants have small molecular weights. Therefore, when a dispersant is blended, the tensile strength and elongation of the matrix decrease. If the compatibility between a dispersant and a matrix is poor, the dispersant may bleed out to impair the properties of the matrix surface. As a result, the adhesiveness to the other material may be reduced, or the dispersant may transfer to the other material to contaminate the other material.

In contrast, when a dispersant is not blended, a matrix can be formed with a polymer having a high affinity for a conductor, thereby preventing agglomeration of the conductor to some degree. In the polymer having a high affinity for a conductor, however, a polar group is often introduced. This sacrifices the tensile strength and elongation of the polymer. The dispersibility of a conductor can also be improved by blending the conductor dispersed in a solvent having a high polarity (for example, N-methylpyrrolidone (NMP) or dimethylformamide (DMF)). However, the solvent having a high polarity has a high boiling point and thus is not easily distilled off. Besides, the solvent having a high polarity cannot dissolve a polymer having a low polarity, so that the types of polymers that can be used as matrices are limited.

The present invention is made in view of the situations described above. It is an object of the present invention to provide an elastic conductive material having good dispersibility of a conductor and excellent elasticity and conductivity. It is another object of the present invention to provide an electrode, wires, and an electromagnetic shield having excellent elasticity and conductivity. It is yet another object of the present invention to provide a transducer and a flexible wiring board that are elastic and have excellent durability.

### Means for Solving the Problem

(1) In order to solve the problem above, an elastic conductive material according to the present invention includes a matrix and a conductor dispersed in the matrix. The elastic conductive material is characterized in that the matrix is formed by crossliking a first polymer that is one or more selected from polymers of General Formulae (1) to (4) below and has a function of dispersing the conductor, and a second polymer crosslinkable with the first polymer
[in Formulae (1) to (4), X is a substituent crosslinkable with the second polymer; Y is a functional group having an affinity for the conductor; constitutional units A, B, and C each are one kind selected from acrylic acid, methacrylic acid, salts of acrylic acid and methacrylic acid, esters, polybutadiene, polyisoprene, urethane prepolymer, polyether, polyetheramine, polyamine, polyol, and polythiol; and 1, m, and n each are an integer equal to or greater than one].

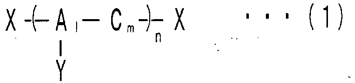

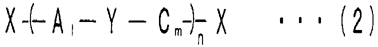

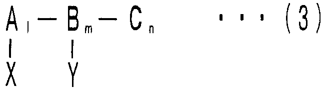

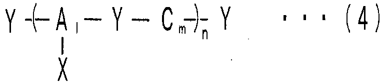

In the elastic conductive material according to the present invention, the first polymer has a function of dispersing the conductor. Accordingly, by crosslinking the first polymer and the second polymer, a matrix with improved dispersibility of the conductor can be formed while taking advantage of the physical properties of these polymers. As a result, an elastic conductive material with good dispersibility of the conductor can be achieved even without blending a dispersant (however, in the elastic conductive material according to the present invention, blending of a dispersant is not intended to be excluded). Accordingly, in the elastic conductive material according to the present invention, the problem caused by bleedout of a dispersant does not easily occur. Furthermore, tensile strength and elongation required as physical properties of a matrix can be ensured.

In the elastic conductive material according to the present invention, the conductor does not easily agglomerate. Therefore, breakage of the matrix initiated at the agglomerate does not easily occur. High conductivity can be achieved even without blending a large amount of the conductor because a conductive network with the conductor is easily formed. That is, the elastic conductive material according to the present invention can achieve both elasticity and conductivity. The conductor is fixed to a mesh structure formed by crosslinking of the first and second polymers. Accordingly, the conductor does not easily move and strip off from the matrix even when expansion/contraction is repeated. Increase in electrical resistance during expansion/contraction is therefore suppressed.

Patent Document 3 discloses a polymer dispersant for dispersing solid fine particles in a solvent. The polymer dispersant, however, is only crosslinked with itself under the presence of a polymerization initiator and does not crosslink with another polymer to form a matrix as in the first polymer according to the present invention.

(2) An electrode according to the present invention is formed of the elastic conductive material of the present invention. The electrode according to the present invention is therefore elastic, has a desired tensile strength and elongation, and has high conductivity. In the electrode according to the present invention, the conductor does not easily agglomerate, so that breakage initiated at the agglomerate does not easily occur. Furthermore, the electrical resistance does not easily increase even with repeated expansion/contraction. In use, therefore, degradation in element performance resulting from increase in electrical resistance of the electrode is small. In the elastic conductive material according to the present invention, no dispersant is blended or a small amount of dispersant is blended, if any. Accordingly, the problem caused by bleedout of a dispersant does not easily occur also in the electrode according to the present invention.

(3) A wire according to the present invention is formed of the elastic conductive material of the present invention. The wire according to the present invention is therefore elastic, has a desired tensile strength and elongation, and also has high conductivity. In the wire according to the present invention, the conductor does not easily agglomerate, so that breakage initiated at the agglomerate does not easily occur. Furthermore, the electrical resistance does not easily increase even with repeated expansion/contraction. In use, therefore, degradation in element performance resulting from increase in electrical resistance of the wire is small. The problem caused by bleedout of a dispersant does not easily occur also in the wire of the present invention as in the electrode of the present invention.

(4) An electromagnetic shield according to the present invention is formed of the elastic conductive material of the present invention. The electromagnetic shield according to the present invention can be formed, for example, from a coating material obtained by dissolving raw materials including polymer materials, a conductor, and the like that constitute the elastic conductive material of the present invention, in a predetermined solvent. The electromagnetic shield can also be formed by press-forming or extruding a kneaded product obtained by kneading the raw materials without using a solvent. Accordingly, the electromagnetic shield with less restrictions on shapes can be readily arranged at various positions where shielding against electromagnetic waves is desired.

The electromagnetic shield according to the present invention is elastic, has a desired tensile strength and elongation, and also has high conductivity. In the electromagnetic shield according to the present invention, the conductor does not easily agglomerate, so that breakage initiated at the agglomerate does not easily occur. Furthermore, the electrical resistance does not easily increase even with repeated expansion/contraction. The shield performance does not easily degrade even when the electromagnetic shield is used for a member having expandability/contractibility. The problem caused by bleedout of a dispersant does not easily occur also in the electromagnetic shield of the present invention as in the electrode and the like of the present invention.

(5) A transducer according to the present invention includes a dielectric film made of an elastomer or resin, a plurality of electrodes arranged with the dielectric film interposed therebetween, and a wire connected to each of the plurality of electrodes. At least one of the electrode and the wire is formed of the elastic conductive material of the present invention.

Transducers are devices for converting a kind of energy into another kind of energy. Transducers include an actuator, a sensor, a power generating element, and the like that perform conversion between mechanical energy and electrical energy, and a speaker, a microphone, and the like that perform conversion between acoustic energy and electrical energy.

In the transducer according to the present invention, at least one of the electrode and the wire is formed of the elastic conductive of the present invention. The electrode and the wire formed of the elastic conductive material of the present invention are elastic, have a desired tensile strength and elongation, and also have high conductivity. In the transducer according to the present invention, therefore, a motion of the dielectric film is not significantly restricted by the electrode and the wire. Furthermore, breakage does not easily occur in the electrode and the wire, and the electrical resistance does not easily increase, even with repeated expansion/contraction. In the transducer according to the present invention, degradation in performance resulting from the electrode and the wire does not easily occur. The transducer according to the present invention has excellent durability.

(6) A flexible wiring board according to the present invention includes an elastic substrate and a wire arranged on a surface of the elastic substrate. The flexible wiring board is characterized in that at least a part of the wire is formed of the elastic conductive material of the present invention.

In the flexible wiring board according to the present invention, the wire expands/contracts in accordance with deformation of the elastic substrate. Here, at least a part of the wire is formed of the elastic conductive material of the present invention. The wire formed of the elastic conductive material of the present invention is elastic, has a desired tensile strength and elongation, and also has high conductivity. Furthermore, the electrical resistance does not easily increase even with repeated expansion/contraction. Furthermore, the problem caused by bleedout of a dispersant does not easily occur. In the flexible wiring board according to the present invention, therefore, the performance does not easily degrade even with expansion/contraction. The flexible wiring board according to the present invention has excellent durability.

### BRIEF DESCRIPTION OF THE DRAWINGS

[FIG. 1] FIG. 1 is a sectional schematic diagram of an actuator serving as a first embodiment of a transducer according to the present invention, in which FIG. 1 (a) shows a voltage OFF state and FIG. 1 (b) shows a voltage ON state.
[FIG. 2] FIG. 2 is a top view of a capacitive sensor serving as a second embodiment of the transducer according to the present invention.
[FIG. 3] FIG. 3 is a sectional view along III-III in FIG. 2.
[FIG. 4] FIG. 4 is a sectional schematic diagram of a power generating element serving as a third embodiment of the transducer according to the present invention, in which FIG. 4(a) shows the power generating element during elongation and FIG. 4(b) shows the power generating element during contraction.
[FIG. 5] FIG. 5 is a perspective view of a speaker serving as a fourth embodiment of the transducer according to the present invention.
[FIG. 6] FIG. 6 is a sectional view along VI-VI in FIG. 5.
[FIG. 7] FIG. 7 is a top perspective view of a flexible wiring board according to the present invention.

### Description of the Reference Numerals

1: Actuator (transducer), 10: dielectric film, 11a, 11b: electrode, 12a, 12b: wire, 13: power supply.
2: Capacitive sensor (transducer), 20: dielectric film, 21a, 21b: electrode, 22a, 22b: wire, 23a, 23b: cover film, 24: connector.
3: Power generating element (transducer), 30: dielectric film, 31a, 31b: electrode, 32a to 32c: wire.
4: Speaker (transducer), 40a: first outer frame, 40b: second outer frame, 41 a: first inner frame, 41b: second inner frame, 42a: first dielectric film, 42b: second dielectric film, 43a: first outer electrode, 43b: second outer electrode, 44a: first inner electrode, 44b: second inner electrode, 45a: first vibration plate, 45b: second vibration plate, 430a, 430b, 440a, 440b: terminal, 460: bolt, 461:nut, 462: spacer.
5: Flexible wiring board, 50: elastic substrate, 51: front wiring connector, 52: back wiring connector, 01X to 16X: front electrode, 01Y to 16Y: back electrode, 01x to 16x: front wire, 01y to 16y: back wire.

### MODES FOR CARRYING OUT THE INVENTION

First, an embodiment of an elastic conductive material according to the present invention will be described below. Next, embodiments of an electrode, a wire, a transducer, a flexible wiring board, and an electromagnetic shield according to the present invention will be described. It should be noted that the elastic conductive material, the electrode, the wire, the transducer, the flexible wiring board, and the electromagnetic shield according to the present invention are not limited to the embodiments below and may be embodied in various modifications, improvements, and the like that can be made by a person skilled in the art without departing from the scope of the present invention.

### <Elastic Conductive Material>

An elastic conductive material according to the present invention includes a matrix and a conductor dispersed in the matrix. The matrix is formed by crosslinking a first polymer and a second polymer. The first polymer has a function of dispersing the conductor and is crosslinkable with the second polymer. The first polymer is formed of one or more selected from polymers of Formulae (1) to (4).

In Formulae (1) to (4), X is a substituent crosslinkable with the second polymer. Specific examples of X include a hydroxyl group, an amino group, a thiol group, a carboxyl group, and a silanol group. X may be one or more selected from these substituents. For example, one polymer may have different substituents.

Y is a functional group having an affinity for the conductor. The inclusion of the functional group Y improves wettability and dispersibility of the conductor in the matrix. Specific examples of Y include an amino group and a quaternary ammonium salt.

The constitutional units A, B, and C each are one kind selected from acrylic acid, methacrylic acid, and salts thereof, esters, polybutadiene, polyisoprene, urethane prepolymer, polyether, polyetheramine, polyamine, polyol, and polythiol. A, B, and C may be the same or different. In Formula (3), the order in which A, B, and C are arranged is not limited. That is, A, B, and C may be arranged at random.

The mass-average molecular weight of the polymer of Formulae (1) to (4) is preferably 500 or more and three million or less. The preferred mass-average molecular weight is 1000 or more. When the mass-average molecular weight of the polymer is less than 500, crosslinking with the second polymer does not fully form a three-dimensional mesh structure. As a result, the desired tensile strength and elongation of the matrix cannot be obtained. On the other hand, when the mass-average molecular weight of the polymer is three million or more, the viscosity increases. Therefore, in cases where electrodes and the like are formed, for example, it is difficult to form a coating material.

The second polymer is not specifically limited as long as it is crosslinkable with the first polymer. As the second polymer, one polymer may be used singly, or two or more polymers may be used in combination. For example, it is preferable to use a rubber polymer having a glass transition temperature (Tg) of 0°C or lower. Rubber with Tg of 0°C or lower has rubber-like resiliency at room temperature and is highly elastic. When Tg is lower, the crystallinity decreases, and the elongation at break (E_{b}) of the rubber increases. That is, the rubber expands more easily. In view of the foregoing, a rubber polymer with Tg of -20°C or lower, more preferably -35°C or lower, is suitable. For example, an acrylic rubber polymer, a hydrin rubber polymer, and a urethane rubber polymer are suitable. Among these, acrylic rubber has a lower Tg compared to the other rubbers because the crystallinity is low and the intermolecular force is weak. Therefore, acrylic rubber is elastic and extensible and is suitable for, for example, electrodes of transducers.

The second polymer preferably has a high affinity for the conductor. It is preferable that the second polymer be easily crosslinked with the first polymer. For example, an epoxy group has a high affinity for carbon black and has high reactivity with the substituent X contained in the first polymer. Therefore, when carbon black is used as the conductor, a polymer having an epoxy group is suitable as the second polymer.

In order to improve the dispersibility of the conductor, it is better to increase the blended amount of the first polymer. In contrast, in order to improve the elasticity of the matrix, it is better to reduce the blended amount of the first polymer. Thus, the blended amount of the first polymer can be determined so as to achieve both the dispersibility of the conductor and the elasticity of the matrix. For example, it is preferable that the blended amount of the first polymer be 5% by mass or more and 90% by mass or less when the elastic conductive material as a whole is 100% by mass. When tensile strength, elongation, and the like of the matrix are taken into consideration, it is preferable that the blended amount of the first polymer be 60% by mass or less.

The kind of the conductor is not particularly limited. The conductor may be appropriately selected from carbon materials such as carbon black, carbon nanotubes, and graphite, metal powders such as silver, gold, copper, nickel, rhodium, palladium, chromium, titanium, platinum, iron, and alloys thereof, and the like. The conductor may be used singly or in a combination of two or more. Among these, carbon black and carbon nanotubes are preferred because a change in conductivity during elongation is small.

A metal-coated non-metallic particle may be used. In this case, the specific gravity of the conductor can be reduced when compared with a case where the conductor is formed only from a metal. This reduces precipitation of the conductor and improves dispersibility when a coating material is formed. With treatment on particles, conductors in various shapes can be easily produced. The cost of the conductor can be reduced. A metal material listed above such as silver may be used for the metal to be coated. Examples of the non-metallic particle include carbon materials such as carbon black, metal oxides such as calcium carbonate, titanium dioxide, aluminum oxide, and barium titanate, inorganic substances such as silica, and resins such as acrylic and urethane resins.

The blended amount of the conductor may be appropriately determined so as to achieve both conductivity and elasticity. For example, in view of ensuring conductivity as electrodes, the blended amount of the conductor is preferably 5 vol% or more when the volume of the elastic conductive material is 100 vol%. More preferably, the blended amount of the conductor is 10 vol% or more. However, when the blended amount of the conductor increases, the elasticity decreases. Therefore, the blended amount of the conductor is preferably 50 vol% or less when the volume of the elastic conductive material is 100 vol%. More preferably, the blended amount of the conductor is 25 vol% or less.

The elastic conductive material according to the present invention can be produced by kneading a composition before crosslinking including the first polymer, the second polymer, and the conductor, using, for example, a pressure kneading machine such as a kneader and a Banbury mixer, or a two-roll kneader, and thereafter press-forming or extruding the kneaded product. Alternatively, the elastic conductive material may be produced as follows. First, the first polymer and the second polymer are dissolved in a solvent. The conductor is then added to the solution, stirred, and mixed to prepare a coating material (the composition before crosslinking). The prepared coating material is then applied to a substrate or the like, and the coating film is heated and dried while a crosslinking reaction is caused to proceed.

The composition before crosslinking may include, in addition to the first and second polymers and the conductor, an additive such as a dispersant, a reinforcing agent, a plasticizer, an antioxidant, and a colorant, as necessary. Various well-known methods can be employed as a method for applying the coating material. Examples of the methods include printing methods such as inkjet printing, flexographic printing, gravure printing, screen printing, pad printing, and lithography, a dip method, a spray method, and a bar coating method. For example, when a printing method is employed, it is easy to selectively apply the coating material between a portion to be coated and a portion not to be coated. A large area, a thin line, and a complicated shape can be easily printed. Among printing methods, screen printing is preferred because a high-viscosity coating material can be used and the adjustment of the coating thickness is easy.

### <Electrode, Wire, and Transducer>

A transducer according to the present invention includes a dielectric film made of an elastomer or resin, a plurality of electrodes arranged with the dielectric film interposed therebetween, and a wire connected to each of the plurality of electrodes. The transducer according to the present invention may have a stack structure in which a dielectric film and an electrode are alternately stacked.

The dielectric film is formed of an elastomer or resin. Among them, an elastomer having a high dielectric constant is preferred. Specifically, the dielectric constant (100 Hz) at room temperature is preferably two or more, more preferably five or more. For example, an elastomer having a polar functional group such as an ester group, a carboxyl group, a hydroxyl group, a halogen group, an amide group, a sulfone group, a urethane group, and a nitrile group, or an elastomer to which a polar low-molecular-weight compound having the polar functional group may be used. Examples of the preferred elastomer include silicone rubber, acrylonitrile-butadiene rubber (NBR), hydrogenated acrylonitrile-butadiene rubber (H-NBR), ethylene-propylene-diene rubber (EPDM), acrylic rubber, urethane rubber, epichlorohydrin rubber, chlorosulfonated polyethylene, and chlorinated polyethylene. It should be noted that "made of an elastomer or resin" means that a base material of the dielectric film is an elastomer or a resin. Any other component such as an additive may be contained in addition to an elastomer or resin component.

The thickness of the dielectric film can be determined appropriately depending on applications of the transducer. For example, in the case of an actuator, the thickness of the dielectric film is preferably small in view of size reduction, low-voltage drive, and a larger displacement. In this case, also taking the dielectric breakdown characteristic into consideration, the thickness of the dielectric film is preferably 1 µm or more and 1000 µm (1 mm) or less. More preferably, the thickness of the dielectric film is 5 µm or more and 200 µm or less.

At least one of the electrode and the wire is formed of the elastic conductive material according to the present invention. The configuration of the elastic conducive material according to the present invention and the method of producing the same are as described above. A description thereof is therefore omitted here. It is preferable that the preferred forms of the elastic conductive material according to the present invention also be employed in the electrode and the wire of the transducer according to the present invention. Embodiments of an actuator, a capacitive sensor, a power generating element, and a speaker will be described below as examples of the transducer according to the present invention. In the embodiments below, embodiments of the electrode and the wire according to the present invention are also described together.

### [First Embodiment]

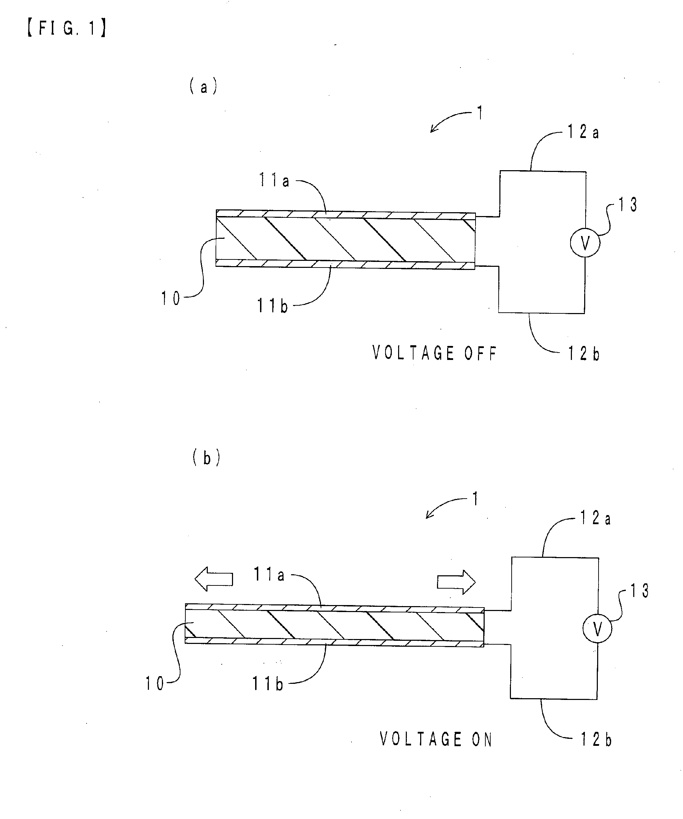

An embodiment of an actuator will be described as a first example of the transducer according to the present invention. FIG. 1 is a sectional schematic diagram of an actuator of the present embodiment. FIG. 1(a) shows a voltage OFF state, and FIG. 1(b) shows a voltage ON state.

As shown in FIG. 1, an actuator 1 includes a dielectric film 10, electrodes 11a and 11b, and wires 12a and 12b. The dielectric film 10 is made of silicone rubber. The electrode 11a is arranged so as to cover the approximately entire upper surface of the dielectric film 10. Similarly, the electrode 11b is arranged so as to cover the approximately entire lower surface of the dielectric film 10. The electrodes 11a and 11b are connected to a power supply 13 through wires 12a and 12b, respectively. The electrodes 11a and 11b are formed of the elastic conductive material of the present invention.

In order to change the OFF state to the ON state, voltage is applied between a pair of the electrodes 11a and 11b. With the application of voltage, the thickness of the dielectric film 10 decreases so that the dielectric film 10 expands in a direction parallel to the surfaces of the electrodes 11a and 11b, accordingly, as shown by white arrows in FIG. 1(b). As a result, the actuator 1 outputs driving force in the up-down direction and the left-right direction in the figure.

According to the present embodiment, the electrodes 11a and 11b are elastic, have a desired tensile strength and elongation, and also have high conductivity. Therefore, the motion of the dielectric film 10 is not significantly restricted by the electrodes 11a and 11b. Accordingly, the actuator 1 provides a large force and displacement. In the electrodes 11a and 11b, the dispersibility of the conductor is good. Therefore, the electrodes 11a and 11b are not easily broken even with repeated expansion/contraction. The conductor is fixed to the mesh structure of the matrix. Therefore, the electrical resistance does not easily increase even with repeated expansion/contraction. Furthermore, the problem caused by bleedout of a dispersant does not easily occur. Accordingly, in the actuator 1, degradation in performance resulting from the electrodes 11a and 11b does not easily occur. The actuator 1 also has excellent durability.

### [Second Embodiment]

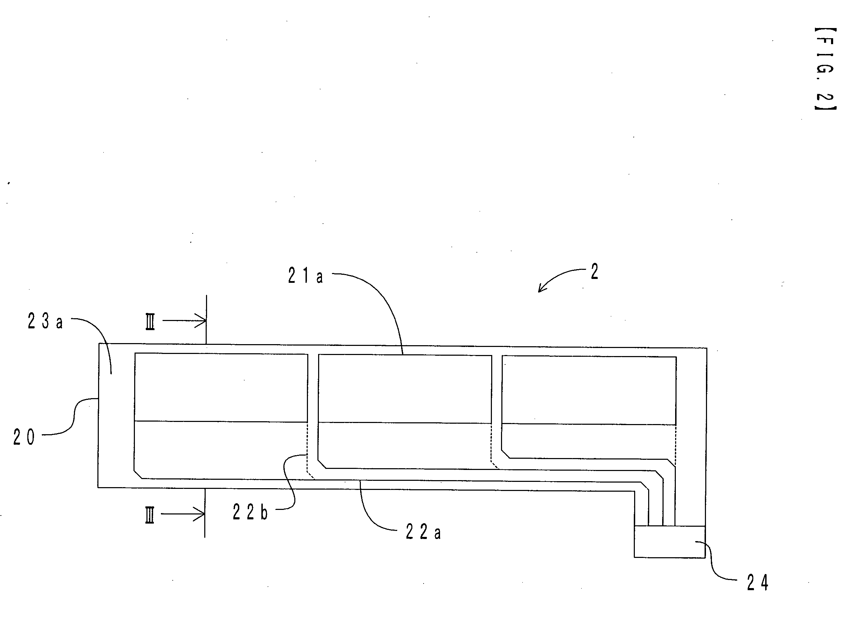

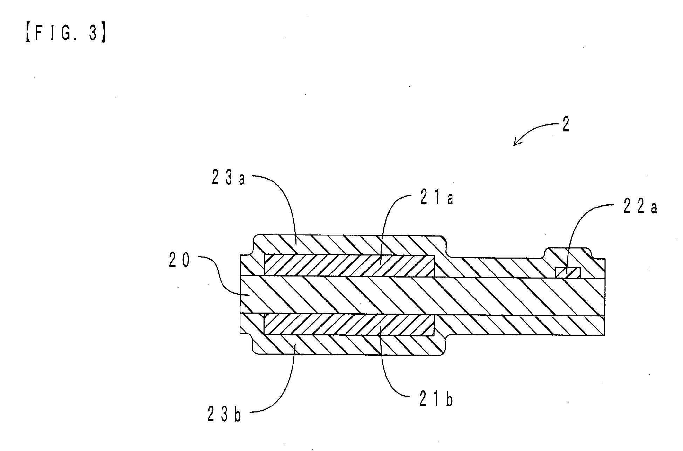

An embodiment of a capacitive sensor will be described as a second example of the present invention. First, a configuration of a capacitive sensor of the present embodiment is described. FIG. 2 shows a top view of a capacitive sensor. FIG. 3 shows a sectional view along III-III in FIG. 2. As shown in FIG. 2 and FIG. 3, a capacitive sensor 2 includes a dielectric film 20, a pair of electrodes 21a and 21b, wires 22a and 22b, and cover films 23a and 23b.

The dielectric film 20 is made of H-NBR and has the shape of a strip extending in the left-right direction. The thickness of the dielectric film 20 is approximately 300 µm.

The electrodes 21 a each have a rectangular shape. Three electrodes 21 a are formed on the upper surface of the dielectric film 20 by screen printing. Similarly, the electrodes 21b each have a rectangular shape. Three electrodes 21b are formed on the lower surface of the dielectric film 20 so as to face the electrodes 21a with the dielectric film 20 interposed therebetween. The electrodes 21b are screen-printed on the lower surface of the dielectric film 20. In this manner, three pairs of electrodes 21 a and 21b are arranged with the dielectric film 20 interposed therebetween. The electrodes 21a and 21b are formed of the elastic conductive material according to the present invention.

The wires 22a each are connected to each of the electrodes 21 a formed on the upper surface of the dielectric film 20. The electrodes 21a are coupled to a connector 24 through the wires 22a. The wires 22a are formed on the upper surface of the dielectric film 20 by screen printing. Similarly, the wires 22b each are connected to each of the electrodes 21b formed on the lower surface of the dielectric film 20 (shown by dotted lines in FIG. 2). The electrodes 21b are coupled to a connector (not shown) through the wires 22b. The wires 22b are formed on the lower surface of the dielectric film 20 by screen printing. The wires 22a and 22b are formed of the elastic conductive material according to the present invention.

The cover film 23a is made of acrylic rubber and has the shape of a strip extending in the left-right direction. The cover film 23a covers the upper surface of the dielectric film 20, the electrodes 21a, and the wires 22a. Similarly, the cover film 23b is made of acrylic rubber and has the shape of a strip extending in the left-right direction. The cover film 23b covers the lower surface of the dielectric film 20, the electrodes 21b, and the wires 22b.

The motion of the capacitive sensor 2 will now be described. For example, when the capacitive sensor 2 is pressed from above, the dielectric film 20, the electrode 21a, and the cover film 23a are integrally curved downward. As a result of the compression, the thickness of the dielectric film 20 decreases. The capacitance between the electrodes 21a and 21b increases. A deformation by compression is detected based on this capacitance change.

The operation and effects of the capacitive sensor 2 will now be described. According to the present embodiment, the electrodes 21a and 21b and the wires 22a and 22b are elastic, have a desired tensile strength and elongation, and also have high conductivity. Therefore, the motion of the dielectric film 20 is not significantly restricted by the electrodes 21a and 21b and the wires 22a and 22b. The conductor is fixed to the mesh structure of the matrix. Therefore, the electrical resistance does not easily increase even with repeated expansion/contraction. Accordingly, the responsibility of the capacitive sensor 2 is good. In the electrodes 21 a and 21b and the wires 22a and 22b, the dispersibility of the conductor is good. Therefore, the electrodes 21a and 21b and the wires 22a and 22b are not easily broken even with repeated expansion/contraction. Furthermore, the problem caused by bleedout of a dispersant does not easily occur. The capacitive sensor 2 therefore has excellent durability. In the capacitive sensor 2 of the present embodiment, three pairs of electrodes 21a and 21b that face each other with the dielectric film 20 interposed therebetween are formed. However, the number, size, shape, arrangement, and the like of the electrodes can be determined appropriately depending on the applications.

### [Third Embodiment]

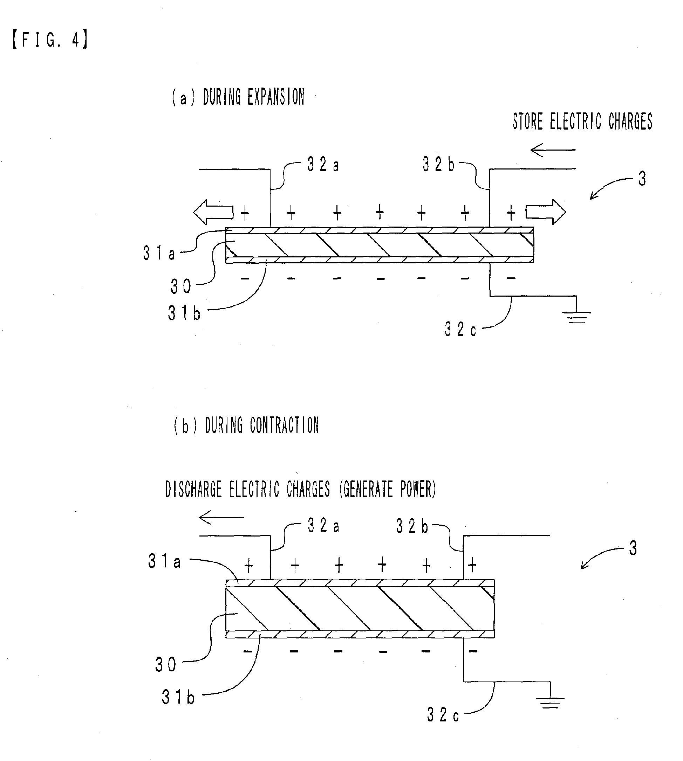

An embodiment of a power generating element will be described as a third example of the transducer according to the present invention. FIG. 4 is a sectional schematic diagram of a power generating element of the present embodiment. FIG. 4(a) shows the power generating element during elongation, and FIG. 4(b) shows the power generating element during contraction.

As shown in FIG. 4, a power generating element 3 includes a dielectric film 30, electrodes 31a and 31b, and wires 32a to 32c. The dielectric film 30 is made of H-NBR. The electrode 31a is arranged so as to cover the approximately entire upper surface of the dielectric film 30. Similarly, the electrode 31b is arranged so as to cover the approximately entire lower surface of the dielectric film 30. The wires 32a and 32b are connected to the electrode 31 a. That is, the electrode 31 a is connected to an external load (not shown) through the wire 32a. The electrode 31 a is also connected to a power supply (not shown) through the wire 32b. The electrode 31b is grounded through the wire 32c. The electrodes 31a and 31b are formed of the elastic conductive material according to the present invention.

As shown by white arrows in FIG. 4(a), when the power generating element 3 is compressed and the dielectric film 30 is expanded in a direction parallel to the surfaces of the electrodes 31a and 31b, the film thickness of the dielectric film 30 decreases, and electric charges are stored between the electrodes 31a and 31b. When the compressing force is thereafter removed, as shown in FIG. 4(b), the elastic restoring force of the dielectric film 30 causes the dielectric film 30 to contract and increases the film thickness. At this moment, the stored electric charges are discharged through the wire 32a.

According to the present embodiment, the electrodes 31a and 31b are elastic, have a desired tensile strength and elongation, and also have high conductivity. Therefore, the motion of the dielectric film 30 is not significantly restricted by the electrodes 31a and 31b. In the electrodes 31a and 31b, the dispersibility of the conductor is good. Therefore, the electrodes 31a and 31b are not easily broken even with repeated expansion/contraction. The conductor is fixed to the mesh structure of the matrix. Therefore, the electrical resistance does not easily increase even with repeated expansion/contraction. Furthermore, the problem caused by bleedout of a dispersant does not easily occur. In the power generating element 3, therefore, degradation in performance resulting from the electrodes 31a and 31b does not easily occur. The power generating element 3 also has excellent durability.

### [Fourth Embodiment]

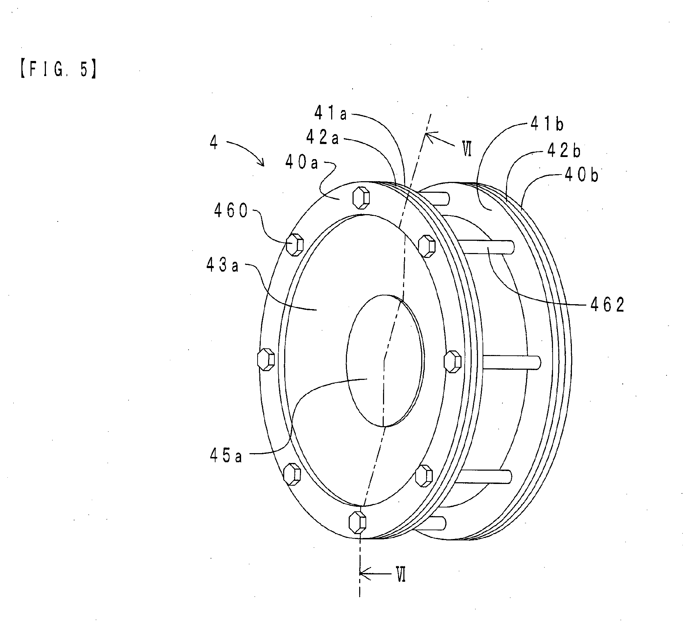

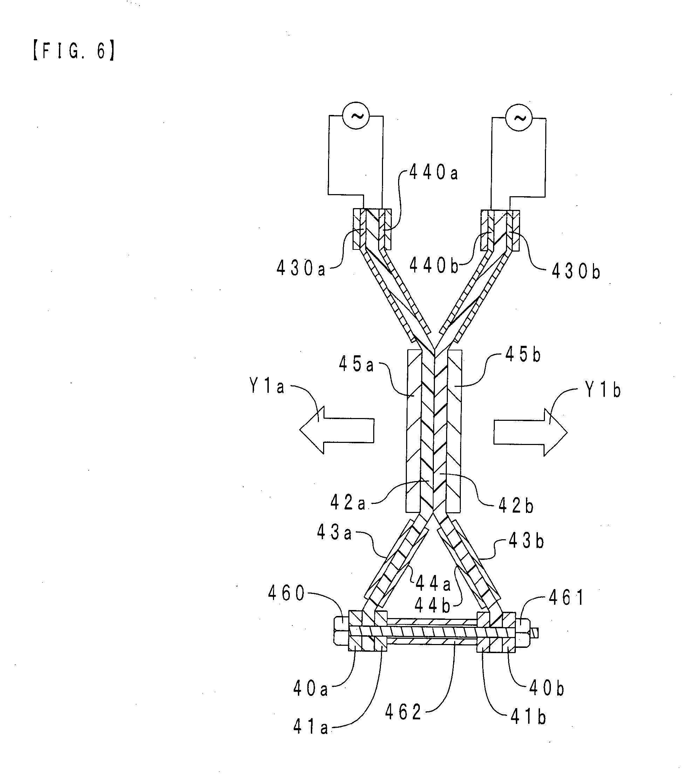

An embodiment of a speaker will be described as a fourth example of the transducer according to the present invention. First, a configuration of a speaker of the present embodiment will be described. FIG. 5 is a perspective view of a speaker of the present embodiment. FIG. 6 is a sectional view along VI-VI in FIG. 5. As shown in FIG. 5 and FIG. 6, a speaker 4 includes a first outer frame 40a, a first inner frame 41 a, a first dielectric film 42a, a first outer electrode 43a, a first inner electrode 44a, a first vibration plate 45a, a second outer frame 40b, a second inner frame 41b, a second dielectric film 42b, a second outer electrode 43b, a second inner electrode 44b, a second vibration plate 45b, eight bolts 460, eight nuts 461, and eight spacers 462.

The first outer frame 40a and the first inner frame 41a each are made of resin and have the shape of a ring. The first dielectric film 42a is made of H-NBR and has the shape of a circular thin film. The first dielectric film 42a is stretched tightly between the first outer frame 40a and the first inner frame 41a. That is, the first dielectric film 42a is held and fixed, with a predetermined tension kept, between the first outer frame 40a on the front side and the first inner frame 41 a on the back side. The first vibration plate 45a is made of resin and has the shape of a disk. The first vibration plate 45a has a diameter smaller than the first dielectric film 42a. The first vibration plate 45a is arranged approximately at the center of the front surface of the first dielectric film 42a.

The first outer electrode 43a has the shape of a ring. The first outer electrode 43a is affixed to the front surface of the first dielectric film 42a. The first inner electrode 44a also has the shape of a ring. The first inner electrode 44a is affixed to the back surface of the first dielectric film 42a. The first outer electrode 43a and the first inner electrode 44a are arranged back-to-back in the front-back direction with the first dielectric film 42a interposed therebetween. The first outer electrode 43a and the first inner electrode 44a are both formed of the elastic conductive material according to the present invention. As shown in FIG. 6, the first outer electrode 43a has a terminal 430a. The first inner electrode 44a has a terminal 440a. Voltage is externally applied to the terminals 430a and 440a.

The configuration, material, and shape of the second outer frame 40b, the second inner frame 41b, the second dielectric film 42b, the second outer electrode 43b, the second inner electrode 44b, and the second vibration plate 45b (hereinafter collectively called "second member") are the same as the configuration, material, and shape of the first outer frame 40a, the first inner frame 41 a, the first dielectric film 42a, the first outer electrode 43a, the first inner electrode 44a, and the first vibration plate 45a described above (hereinafter collectively called "first member"). The arrangement of the second member is symmetric to the arrangement of the first member described above in the front-back direction. Briefly speaking, the second dielectric film 42b is made of H-NBR and is stretched tightly between the second outer frame 40b and the second inner frame 41b. The second vibration plate 45b is arranged approximately at the center of the front surface of the second dielectric film 42b. The second outer electrode 43b is printed on the front surface of the second dielectric film 42b. The second inner electrode 44b is printed on the back surface of the second dielectric film 42b. The second outer electrode 43b and the second inner electrode 44b are both formed of the elastic conductive material according to the present invention. Voltage is externally applied to a terminal 430b of the second outer electrode 43b and a terminal 440b of the second inner electrode 44b.

The first member and the second member are fixed to each other with the eight spacers 462 interposed therebetween with the eight bolts 460 and the eight nuts 461. Sets of "the bolt 460 - the nut 461 - the spacer 462" are arranged so as to be spaced apart from each other at predetermined intervals in the circumferential direction of the speaker 4. The bolt 460 passes through from the front surface of the first outer frame 40a to the front surface of the second outer frame 40b. The nut 461 is screwed onto the distal end of the bolt 460. The spacer 462 is made of resin and is provided surrounding the shaft of the bolt 460. The spacer 462 keeps a predetermined distance between the first inner frame 41a and the second inner frame 41b. The back surface of the central portion of the first dielectric film 42a (the back side of a part where the first vibration plate 45a is arranged) and the back surface of the central portion of the second dielectric film 42b (the back side of a part where the second vibration plate 45b is arranged) are joined to each other. In the first dielectric film 42a, therefore, biasing force is accumulated in the direction shown by a white arrow Y1a in FIG. 6. In the second dielectric film 42b, biasing force is accumulated in the direction shown by a white arrow Y1b in FIG. 6.

The motion of the speaker of the present embodiment will now be described. A predetermined voltage (offset voltage) is applied in an initial state (offset state) between the first outer electrode 43a and the first inner electrode 44a and between the second outer electrode 43b and the second inner electrode 44b through the terminals 430a and 440a and the terminals 430b and 440b. In operation of the speaker 4, voltages of opposite phases are applied to the terminals 430a and 440a and the terminals 430b and 440b. For example, when an offset voltage +1V is applied to the terminals 430a and 440a, the film thickness decreases at a part of the first dielectric film 42a that is arranged between the first outer electrode 43a and the first inner electrode 44a. This part also expands radially. Simultaneously, a voltage of an opposite phase (offset voltage -1V) is applied to the terminals 430b and 440b. In response, the film thickness increases at a part of the second dielectric film 42b that is arranged between the second outer electrode 43b and the second inner electrode 44b. This part also contracts radially. Accordingly, the second dielectric film 42b elastically deforms with its own biasing force in the direction shown by the white arrow Y1b in FIG. 6 while pulling the first dielectric film 42a. Conversely, when an offset voltage +1V is applied to the terminals 430b and 440b and a voltage of an opposite phase (offset voltage -1V) is applied to the terminals 430a and 440a, the first dielectric film 42a is elastically deforms with its own biasing force in the direction shown by the white arrow Y1a in FIG. 6 while pulling the second dielectric film 42b. In this way, the first vibration plate 45a and the second vibration plate 45b are vibrated to vibrate the air, thereby producing sound.

The operation and effects of the speaker 4 of the present embodiment will now be described. According to the present embodiment, the first outer electrode 43a, the first inner electrode 44a, the second outer electrode 43b, and the second inner electrode 44b (hereinafter called "electrodes 43a, 44a, 43b, 44b" as appropriate) are elastic, have a desired tensile strength and elongation, and also have high conductivity. Therefore, the motion of the first dielectric film 42a and the second dielectric film 42b is not significantly restricted by the electrodes 43a, 44a, 43b, and 44b. The responsibility of the speaker 4 is thus good even in a low frequency region. In the electrodes 43a, 44a, 43b, and 44b, the dispersibility of the conductor is good. Therefore, the electrodes 43a, 44a, 43b, and 44b are not easily broken even with repeated expansion/contraction. The conductor is fixed to the mesh structure of the matrix. Therefore, the electrical resistance does not easily increase even with repeated expansion/contraction. Furthermore, the problem caused by bleedout of a dispersant does not easily occur. In the speaker 4, therefore, degradation in performance resulting from the electrodes 43a, 44a, 43b, and 44b does not easily occur. The speaker 4 also has excellent durability.

### <Flexible Wiring Board>

A flexible wiring board according to the present invention includes an elastic substrate and a wire arranged on a surface of the elastic substrate. The material of the elastic substrate is not particularly limited. For example, examples of the material having expandability/contractibility include silicone rubber, ethylene-propylene copolymer rubber, natural rubber, styrene-butadiene copolymer rubber, acrylonitrile-butadiene rubber (NBR), acrylic rubber, epichlorohydrin rubber, chlorosulfonated polyethylene, chlorinated polyethylene, urethane rubber, fluororubber, chloroprene rubber, isobutylene isoprene rubber, and a variety of thermoplastic elastomers.

At least a part of the wire is formed of the elastic conductive material according to the present invention. The configuration of the elastic conductive material according to the present invention and the method of producing the same are as described above. A description thereof is therefore omitted here. In the flexible wiring board according to the present invention, it is also preferable to employ the preferred forms of the elastic conductive material according to the present invention described above. An embodiment of the flexible wiring board according to the present invention will be described below.

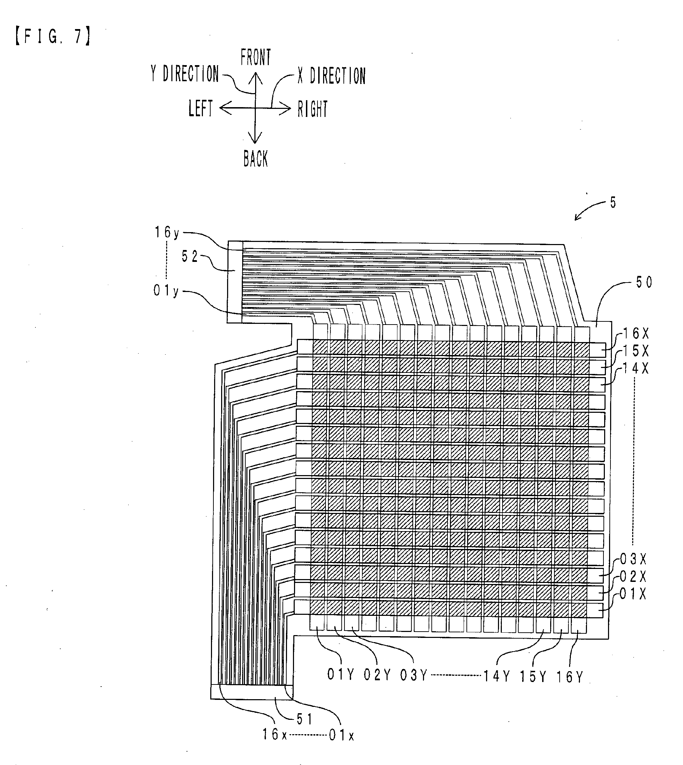

First, a configuration of the flexible wiring board of the present embodiment is described. FIG. 7 shows a top perspective view of the flexible wiring board of the present embodiment. In FIG. 7, the electrodes and the wires on the back side are shown by thin lines. As shown in FIG. 7, a flexible wiring board 5 includes an elastic substrate 50, front electrodes 01X to 16X, back electrodes 01Y to 16Y, front wires 01x to 16x, back wires 01y to 16y, a front wiring connector 51, and a back wiring connector 52.

The elastic substrate 50 is made of urethane rubber and has the shape of a sheet. A total of 16 front electrodes 01X to 16X are arranged on the upper surface of the elastic substrate 50. The front electrodes 01X to 16X each have the shape of a strip. The front electrodes 01X to 16X each extend in the X direction (the left-right direction). The front electrodes 01X to 16X are arranged so as to be spaced apart from each other with a predetermined interval and approximately parallel to each other in the Y direction (the front-back direction). Similarly, a total of 16 back electrodes 01Y to 16Y are arranged on the lower surface of the elastic substrate 50. The back electrodes 01Y to 16Y each have the shape of a strip. The back electrodes 0 1 Y to 16Y each extend in the Y direction. The back electrodes 0 1 Y to 16Y are arranged so as to be spaced apart from each other at a predetermined interval and approximately parallel to each other in the X direction. As shown by hatching in FIG. 7, each of the parts where the front electrodes 01X to 16X and the back electrodes 01Y to 16Y intersect (overlapping parts) with the elastic substrate 50 sandwiched therebetween forms a detector for detecting a load or the like.

A total of 16 pieces of front wires 01x to 16x are arranged on the upper surface of the elastic substrate 50. The front wires 01x to 16x each have the shape of a line. The front wires 01x to 16x are formed of the elastic conductive material according to the present invention. The front wiring connector 51 is arranged at the left back comer of the elastic substrate 50. The front wires 01x to 16x connect the left ends of the front electrodes 01X to 16X with the front wiring connector 51. The upper surface of the elastic substrate 50, the front electrodes 01X to 16X, and the front wires 01x to 16x are covered with a front cover film (not shown) from above.

A total of 16 pieces of back wires 01y to 16y are arranged on the lower surface of the elastic substrate 50. The back wires 01y to 16y each have the shape of a line. The back wires 01y to 16y are formed of the elastic conductive material according to the present invention. The back wiring connector 52 is arranged at the left front corner to the elastic substrate 50. The back wires 01y to 16y connect the front ends of the back electrodes 01Y to 16Y with the back wiring connector 52. The lower surface of the elastic substrate 50, the back electrodes 0 1 Y to 16Y, and the back wires 01y to 16y are covered with a back cover film (not shown) from below.

The front wiring connector 51 and the back wiring connector 52 each are electrically connected to a calculation unit (not shown). The impedance at the detector is input to the calculation unit from the front wires 01x to 16x and the back wires 01y to 16y. Based on this, the surface pressure distribution is measured.

The operation and effects of the flexible wiring board 5 of the present embodiment will now be described. According to the present embodiment, the front wires 01x to 16x and the back wires 01y to 16y each are elastic, have a desired tensile strength and elongation, and also have high conductivity. The front wires 01x to 16x and the back wires 01y to 16y therefore can be deformed in accordance with the deformation of the elastic substrate 50. The conductor is fixed to the mesh structure of the matrix. Therefore, the electrical resistance does not easily increase even with repeated expansion/contraction. The flexible wiring board 5 is therefore suitable for connecting an expandable/contradictable element to an electric circuit. In the front wires 01x to 16x and the back wires 01y to 16y, the dispersibility of the conductor is good. Therefore the front wires 01x to 16x and the back wires 01y to 16y are not easily broken even with repeated expansion/contraction. Furthermore, the problem caused by bleedout of a dispersant does not easily occur. The flexible wiring board 5 therefore has excellent durability.

### <Electromagnetic Shield>

An electromagnetic shield according to the present invention is formed of the elastic conductive material according to the present invention. An electromagnetic shield has a function of prohibiting electromagnetic waves generated inside the electronic equipment from leaking to the outside or to hindering intrusion of external electromagnetic waves to the inside. For example, in the case where an electromagnetic shield is arranged on the inner peripheral surface of a casing of electronic equipment, a coating material for forming the elastic conductive material according to the present invention may be applied to the inner peripheral surface of the casing of the electronic equipment and dried. An electromagnetic shield can also be arranged on the capacitive sensor described as the second embodiment of the transducer. For example, an electromagnetic shield may be arranged so as to cover each of the upper surface of the cover film 23a and the lower surface of the cover film 23b (see FIG. 2 and FIG. 3 above). In this case, a coating material for forming the elastic conductive material according to the present invention may be applied to the upper surface of the cover film 23a and the lower surface of the cover film 23b and dried. In the case where an electromagnetic shield is arranged as a gasket in a gap of electronic equipment, the elastic conductive material according to the present invention can be formed into a desired shape for use.

### Examples

The present invention will be described more specifically with Examples.

### <Production of Elastic Conductive Material>

### [Example 1]

An elastic conductive material was produced using a polymer of structural formula (a) below as the first polymer and a urethane rubber polymer ("ADIPRENE (registered trademark) BL16" manufactured by Chemtura Corporation) as the second polymer. The polymer of structural formula (a) is included in a polymer of Formula (3) above. The mass-average molecular weight of the polymer of structural formula (a) is approximately 1500.

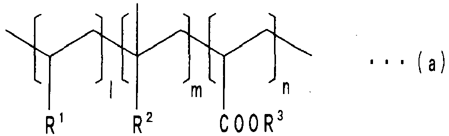

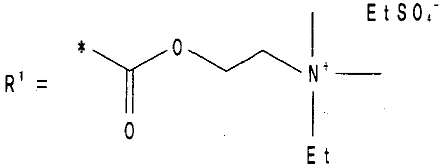

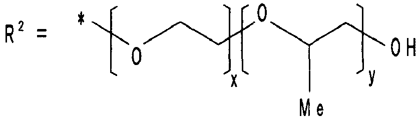

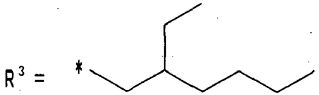

First, 56 parts by mass of the polymer of structural formula (a) above and 24 parts by mass of the urethane rubber polymer were dissolved in 1000 parts by mass of butyl carbitol acetate as a solvent to prepare a polymer solution. Then, 12 parts by mass of a multi-walled carbon nanotube ("VGCF (registered trademark)-X" manufactured by SHOWA DENKO K.K.) as a conductor and 8 parts by mass of conductive carbon black ("CARBON ECP-600JD" manufactured by Lion Corporation) were added to the prepared polymer solution and mixed to prepare a coating material. The prepared coating material was then applied to a surface of an acrylic resin substrate by a bar coating method. The substrate having a coating film formed thereon was allowed to stand in a drying oven at about 150°C for about 30 minutes to dry the coating film and allow a crosslinking reaction to proceed, so that a thin film-like elastic conductive material was obtained. The blended amount of the first polymer in the elastic conductive material is 56% by mass. The blended amount of the conductor is 11 vol%.

### [Example 2]

An elastic conductive material was produced using a polymer of the same structural formula (a) as in Example 1 as the first polymer and a hydroxyl group-containing acrylic rubber polymer in addition to a urethane rubber polymer (the same as above) as the second polymer. The hydroxyl group-containing acrylic rubber polymer is a copolymer of n-butyl acrylate (98% by mass) and 2-hydroxyethyl methacrylate (2% by mass) (the mass molecular weight is approximately 0.9 million).

First, 14.81 parts by mass of the polymer of structural formula (a) above, 22.22 parts by mass of the urethane rubber polymer, and 44.44 parts by mass of the hydroxyl group-containing acrylic rubber polymer were dissolved in 999.9 parts by mass of butyl carbitol acetate to prepare a polymer solution. Then, 11.11 parts by mass of a multi-walled carbon nanotube (the same as above) and 7.41 parts by mass of conductive carbon black (the same as above) were added to the prepared polymer solution and mixed to prepare a coating material. The prepared coating material was then applied to a surface of an acrylic resin substrate by the bar coating method. A thin film-like elastic conductive material was then obtained in the same manner as in Example 1. The blended amount of the first polymer in the elastic conductive material is 14.81 % by mass. The blended amount of the conductor is 10 vol%.

### [Example 3]

An elastic conductive material was produced using a polymer of the same structural formula (a) as in Example 1 as the first polymer and an epoxy group-containing acrylic rubber polymer ("Nipol (registered trademark) AR42W" manufactured by ZEON CORPORATION) as the second polymer.

First, 10.71 parts by mass of the polymer of structural formula (a) and 71.43 parts by mass of the epoxy group-containing acrylic rubber polymer were dissolved in 892.8 parts by mass of butyl carbitol acetate to prepare a polymer solution. Then, 10.71 parts by mass of a multi-walled carbon nanotube (the same as above) and 7.14 parts by mass of conductive carbon black (the same as above) were added to the prepared polymer solution and mixed to prepare a coating material. The prepared coating material was then applied to a surface of an acrylic resin substrate by the bar coating method. A thin film-like elastic conductive material was then obtained in the same manner as in Example 1. The blended amount of the first polymer in the elastic conductive material is 10.71% by mass. The blended amount of the conductor is 10 vol%.

### [Example 4]

An elastic conductive material was produced in the same manner as in Example 3 except that the kind of the first polymer was changed and a polymer of structural formula (b) below (the mass-average molecular weight: approximately 600) was used. The polymer of structural formula (b) is included in the polymer of Formula (2) above.

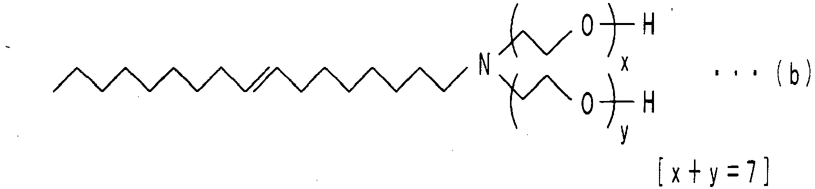

### [Example 5]

An elastic conductive material was produced by additionally blending a 10% dimethylacetamide solution of polyvinyl pyrrolidone (the mass-average molecular weight: 40,000) as a dispersant. First, 7.14 parts by mass of the polymer of structural formula (a) above and 71.43 parts by mass of an epoxy group-containing acrylic rubber polymer (the same as above) were dissolved in 928.5 parts by mass of butyl carbitol acetate to prepare a polymer solution. Then, 10.71 parts by mass of a multi-walled carbon nanotube (the same as above), 7.14 parts by mass of conductive carbon black (the same as above), and 3.57 parts by mass of the 10% dimethylacetamide solution of polyvinyl pyrrolidone were added to the prepared polymer solution and mixed to prepare a coating material. The prepared coating material was then applied to a surface of an acrylic resin substrate by the bar coating method. A thin film-like elastic conductive material was then obtained in the same manner as in Example 1. The blended amount of the first polymer in the elastic conductive material is 7.14% by mass. The blended amount of the conductor is 10 vol%.

### [Comparative Example 1]

An elastic conductive material was produced without blending the first polymer. First, 80 parts by mass of an epoxy group-containing acrylic rubber polymer (the same as above) was dissolved in 1000 parts by mass of butyl carbitol acetate to prepare a polymer solution. Then, 12 parts by mass of a multi-walled carbon nanotube (the same as above) and 8 parts by mass of conductive carbon black (the same as above) were added to the prepared polymer solution and mixed to prepare a coating material. The prepared coating material was then applied to a surface of an acrylic resin substrate by a bar coating method. A thin film-like elastic conductive material was then obtained in the same manner as in Example 1. The blended amount of the conductor in the elastic conductive material is 11 vol%.

### [Comparative Example 2]

An elastic conductive material was produced by blending a dispersant without blending the first polymer. First, 71.43 parts by mass of an epoxy group-containing acrylic rubber polymer (the same as above) was dissolved in 1000 parts by mass of butyl carbitol acetate to prepare a polymer solution. Then, 10.71 parts by mass of a multi-walled carbon nanotube (the same as above), 7.14 parts by mass of conductive carbon black (the same as above), and 10.71 parts by mass of a 10% dimethylacetamide solution of polyvinyl pyrrolidone were added to the prepared polymer solution and mixed to prepare a coating material. The prepared coating material was then applied to a surface of an acrylic resin substrate by the bar coating method. A thin film-like elastic conductive material was then obtained in the same manner as in Example 1. The blended amount of the conductor in the elastic conductive material is 10 vol%.

### [Comparative Example 3]

An elastic conductive material was produced in the same manner as in Comparative Example 1 except that the kind and blended amount of solvent were changed. Specifically, 80 parts by mass of an epoxy group-containing acrylic rubber polymer (the same as above) was dissolved in a mixed solvent of 300 parts by mass of N-methylpyrrolidone (NMP) and 700 parts by mass of butyl carbitol acetate to prepare a polymer solution.

### <Evaluation Method>

### [Dispersibility of Conductor]

The degree of dispersion of the conductor in the prepared coating material was measured in conformity with JIS K5600-2-5 (1999). A case where a readout of a grind gauge was 25 µm or less was evaluated as good (indicated by ○ in Table 1 below), and a case where a readout exceeded 25 µm was evaluated as bad (indicated by × in Table 1).

### [Stability of Coating Material]

The prepared coating material was allowed to stand at room temperature for one month and then observed by visual inspection. A case where no supernatant was produced was evaluated as good (indicated by ○ in Table 1 below), and a case where supernatant was produced was evaluated as bad (indicated by × in Table 1).

### [Conductivity]

The volume resistivity of the produced elastic conductive material was measured by a parallel electrode method in conformity with JIS K6271 (2008). Here, a commercially available silicone rubber sheet (manufactured by KUREHA ELASTOMER CO., LTD.) was used as an insulating resin support for supporting a test piece.

### [Elasticity]

A tensile test was conducted on the produced elastic conductive material in conformity with JIS K6251 (2004). The test piece was shaped into test piece type 2 and expanded at a speed of 100 mm/min. The elongation at break (E_{b}) was then calculated.

### <Evaluation Results>

The evaluation results of the elastic conductive materials in Examples and Comparative Examples are shown with the blended amounts of raw materials in Table 1. In Table 1, the blended amounts of raw materials are shown by parts by mass.

**[Table 1]**

| | | | Example 1 | Example 2 | Example 3 | Example 4 | Example 5 | Comparative Example 1 | Comparative Example 2 | Comparative Example 3 |
|---|---|---|---|---|---|---|---|---|---|---|
| Elastic conductive material | First polymer | polymer of structural formula (a) | 56.00 | 14.81 | 10.71 | - | - | - | - | - |
| | | Polymer or structural formula (b) | - | - | - | 10.71 | 7.14 | - | - | - |
| | Second polymer | Epoxy group-containing acrylic rubber polymer | - | - | 71.43 | 71.43 | 71.43 | 80.00 | 71.43 | 80.00 |
| | | Hydroxyl group-containing acrylic rubber polymer | - | 44.44 | - | - | - | - | - | - |
| | | Urethane rubber polymer | 24.00 | 22.22 | - | - | 2.50 | - | - | - |
| | Conductor. | Multi-walled carbon nanotube | 12.00 | 11.11 | 10.71 | 10.71 | 10.71 | 12.00 | 10.71 | 12.00 |
| | | Conductive carbon black | 8.00 | 7.41 | 7.14 | 7.14 | 7.14 | 8.00 | 7.14 | 8.00 |
| | Dispersant | Polyvinyl pyrrolidone (10% DMAc solution) | - | - | - | - | 3.57 | - | 10.71 | - |
| | Solvent | N-methylpyrrolidone | - | - | - | - | - | - | - | 300 |
| | | Butyl carbitol acetate | 1000 | 999.9 | 892.8 | 892.8 | 928.5 | 1000 | 1000 | 700 |
| Evaluation results | Dispersibility of conductor | | ○ | ○ | ○ | ○ | ○ | × | ○ | × |
| | Stability of coating material | | ○ | ○ | ○ | ○ | ○ | × | ○ | ○ |
| | Volume resistivity [Ω·cm] | | 0.09 | 0.09 | 0.07 | 0.08 | 0.08 | - | 0.14 | - |
| | Elongation at break [%] | | 108 | 124 | 151 | 120 | 116 | - | 89 | - |

As shown in Table 1, in the elastic conductive material in Comparative Example 1 without using the first polymer, the dispersibility of the conductor and the stability of the coating material were both bad. By contrast, in the elastic conductive material in Examples using the first polymer, the dispersibility of the conductor and the stability of the coating material were both good. In the elastic conductive material in Comparative Example 3, although the dispersibility of the conductor was improved because of the use of the high-polarity solvent (NMP), the stability of the coating material was not improved. In the elastic conductive material in Comparative Example 2, the dispersibility of the conductor and the stability of the coating material were both good because a relatively large amount of dispersant was blended.

Based on the values of volume resistivity, it was confirmed that the elastic conductive materials in Examples have high conductivity. In the elastic conductive material in Comparative Example 2, the elongation at break is small because a relatively large amount of dispersant is blended. By contrast, in the elastic conductive materials in Examples, the elongation at break is large. Here, by comparison between Examples 1 to 3, although the second polymers are different, the smaller the blended amount of the first polymer is, the larger the elongation at break is. When Examples 3 to 5 and Comparative Example 2 using the same kind and blended amount of the second polymer are compared, the elongation at break in Examples 3 and 4 using the first polymer without blending a dispersant is significantly larger than the elongation at break in Comparative Example 2 with a dispersant and without using the first polymer. In the elastic conductive material of Example 5, although the first polymer is used, a small amount of dispersant is blended. Because of this, the elongation at break is slightly lower than the elastic conductive material of Example 4.

As described above, it is confirmed that an elastic conductive material with good dispersibility of a conductor and having excellent elasticity and conductivity can be achieved by forming a matrix by crosslinking the first polymer and the second polymer.

### INDUSTRIAL APPLICABILITY

The elastic conductive material according to the present invention is suitable for electrodes and wires for elastic transducers using elastomers. It is also suitable for electromagnetic shields, wires of flexible wiring boards for use in flexible displays, and the like. It is also suitable for conductive adhesive, and electrodes and wires of control devices for movable units of robots and industrial machines and wearable devices.

## Claims

1. An elastic conductive material including: a matrix; and a conductor dispersed in the matrix, the elastic conductive material **characterized in that**
the matrix is formed by crossliking a first polymer that is one or more selected from polymers of General Formulae (1) to (4) below and has a function of dispersing the conductor, and a second polymer crosslinkable with the first polymer, [in Formulae (1) to (4), X is a substituent crosslinkable with the second polymer; Y is a functional group having an affinity for the conductor; constitutional units A, B, and C each are one kind selected from acrylic acid, methacrylic acid, salts of acrylic acid and methacrylic acid, esters, polybutadiene, polyisoprene, urethane prepolymer, polyether, polyetheramine, polyamine, polyol, and polythiol; and 1, m, and n each are an integer equal to or greater than one].

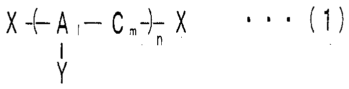

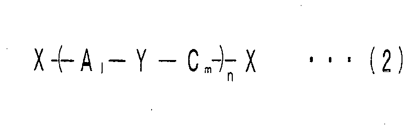

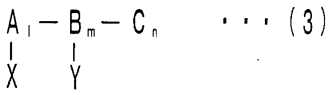

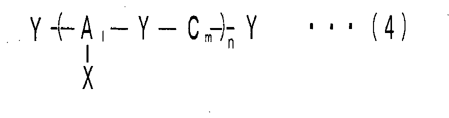

2. The elastic conductive material according to claim 1, wherein in the polymers as the first polymer, the substituent Y is an amino group or a quaternary ammonium salt.

3. The elastic conductive material according to claim 1 or 2, wherein in the polymers as the first polymer, the substituent X is one or more selected from a hydroxyl group, an amino group, a thiol group, a carboxyl group, and a silanol group.

4. The elastic conductive material according to any one of claims 1 to 3, wherein the second polymer includes a rubber polymer having a glass transition temperature (Tg) of 0°C or lower.

5. The elastic conductive material according to claim 4, wherein the rubber polymer is one or more selected from an acrylic rubber polymer, a hydrin rubber polymer, and a urethane rubber polymer.

6. The elastic conductive material according to any one of claims 1 to 5, wherein a blended amount of the first polymer is 5% by mass or more and 90% by mass or less when the elastic conductive material as a whole is 100% by mass.

7. The elastic conductive material according to any one of claims 1 to 6, wherein the conductor is one or more selected from carbon black, carbon nanotubes, graphite.

8. An electrode formed of the elastic conductive material as claimed in any one of claims 1 to 7.

9. A wire formed of the elastic conductive material as claimed in any one of claims 1 to 7.

10. An electromagnetic shield formed of the elastic conductive material as claimed in any one of claims 1 to 7.

11. A transducer comprising:
a dielectric film made of an elastomer or resin;
a plurality of electrodes arranged with the dielectric film interposed therebetween;
and
a wire connected to each of the plurality of electrodes, wherein at least one of the electrode and the wire is formed of the elastic conductive material as claimed in any one of claims 1 to 7.

12. A flexible wiring board comprising:
an elastic substrate; and
a wire arranged on a surface of the elastic substrate, wherein at least a part of the wire is formed of the elastic conductive material as claimed in any one of claims 1 to 7.
